# FASCICULE DE BREVET EUROPEEN

(11) **EP 3 312 565 B1**
(45) Date de publication et mention de la délivrance du brevet: **20.01.2021**
(21) Numéro de dépôt: 17197375.3
(22) Date de dépôt: 19.10.2017
(51) Int. Cl.: G01D 5/14, G01R 33/383

(54) **CAPTEUR DE POSITION**
POSITIONSSENSOR
POSITION SENSOR

(30) Priorité: 19.10.2016 FR 1601516
(43) Date de publication de la demande: 25.04.2018
(73) Titulaire: Thales, 92400 Courbevoie (FR)
(72) Inventeur: CHASSOULIER, Damien, 06370 MOUANS-SARTOUX (FR); BLANC, Alain, 06810 AURIBEAU SUR SIAGNE (FR); CARRON DE LA MORINAIS, Guy, 06400 CANNES (FR)
(74) Mandataire: Marks & Clerk France

(56) Documents cités:
- EP-A1- 0 558 364
- EP-A1- 1 790 950
- US-A1- 2010 308 805
- US-A1- 2011 316 528
- SHUNJI TAHARA ET AL: "Thrust characteristics of 2-pole PMLSM composed of flux concentrated arrangement with Halbach array", ELECTRICAL MACHINES AND SYSTEMS, 2009. ICEMS 2009. INTERNATIONAL CONFERENCE ON, IEEE, PISCATAWAY, NJ, USA, 15 novembre 2009 (2009-11-15), pages 1-4, XP031612181, ISBN: 978-1-4244-5177-7

## Description

L'invention concerne un capteur de position permettant de donner une position absolue d'une partie mobile par rapport à une partie fixe d'un mécanisme.

L'invention trouve une utilité particulière dans des mécanismes se déployant afin de déterminer la position de la partie mobile par rapport à la partie fixe. Ce type de capteur peut notamment être mis en œuvre dans un satellite où certains appendices comme des panneaux solaires ou des éléments d'antenne sont déployés dans l'espace. L'invention peut trouver une autre utilité dans les machines électriques, moteur ou générateur, dans lesquelles il est utile de connaitre la position du rotor par rapport au stator, par exemple pour retrouver à chaque tour une position de référence absolue. De façon plus générale, l'invention peut être mise en œuvre dans tout mécanisme possédant une partie mobile dont on veut connaître la position absolue en un point de sa course.

Pour réaliser une mesure de position sans contact entre les deux parties du mécanisme, on peut utiliser un capteur à effet Hall disposé sur l'une des parties. Le capteur détecte le passage d'un composant magnétique disposé sur l'autre partie du mécanisme. Dans un moteur électrique, il est par exemple possible de connaitre la position d'un pôle du rotor au moyen d'un capteur à effet hall placé sur le stator.

Il existe d'autres capteurs magnétiques réalisés sous forme d'un interrupteur sensible au champ magnétique. Ces interrupteurs sont connus dans la littérature anglo-saxonne sous le nom d'interrupteur « Reed ». Ils comprennent des lames métalliques magnétisées venant au contact l'une de l'autre lorsqu'un champ magnétique suffisant les traverse. Ces capteurs permettent la détection d'un aimant permanent lorsqu'il s'approche du capteur.

De façon générale les capteurs magnétiques « Reed » sont assez peu précis. En effet, de nombreux paramètres tels que la température peuvent faire varier l'intensité du champ magnétique au voisinage du capteur. La détection est alors soumise aux aléas de l'environnement. Dans un aimant permanent une variation de température influe directement sur l'intensité du champ magnétique généré par l'aimant. De plus dans un mécanisme complexe, une variation de température entraine souvent des variations dimensionnelles des pièces mécaniques du mécanisme qui sont susceptibles de faire évoluer une distance séparant le capteur de l'aimant et donc l'intensité du champ magnétique détecté par le capteur.

Les documents EP 0558 364 A1 et US 2010/308805 A1 décrivent des capteurs magnétiques se déplacçant dans des champs magnétiques réalisés à l'aide d'une combinaison d'aimants permanents.

D'autres types de capteurs peuvent également être utilisés pour déterminer, sans contact, une position d'une partie mobile par rapport à une partie fixe, par exemple un capteur optique. Un émetteur lumineux est disposé sur une des parties et un réflecteur sur l'autre partie. Un capteur optique est disposé à proximité de l'émetteur. Le capteur peut alors détecter un rayonnement issu de l'émetteur et réfléchi par le réflecteur. Les capteurs optiques sont généralement plus précis que les capteurs magnétiques. Néanmoins leur coût est généralement beaucoup plus élevé.

L'invention vise à pallier tout ou partie des problèmes cités plus haut en proposant un nouveau capteur de position précis, d'un coût faible et basé sur une détection magnétique.

A cet effet, l'invention a pour objet un capteur de position défini par la revendication 1.

Le capteur selon l'invention est capable de donner une position de référence absolue. Il est peu onéreux, précis, insensible à la température et insensible aux dilations thermo-élastiques du mécanisme dans lequel il est monté.

Selon l'invention, les pôles de chacun des aimants sont disposés sur des axes parallèles entre eux, les deux éléments sont destinés à se déplacer l'un par rapport à l'autre selon un axe perpendiculaire aux axes des pôles des aimants. Selon cette direction de déplacement dite direction privilégiée, le champ magnétique évolue de façon linéaire, notamment lorsque l'élément sensible passe au droit d'une jonction entre les aimants de chaque paire. Perpendiculairement à cette direction de déplacement, le champ magnétique évolue peu. En conséquence le capteur est très tolérant à des déplacements perpendiculaires à la direction privilégiée. Lors de ces déplacements perpendiculaires, l'élément sensible ne fera quasiment aucune variation de détection.

Le composant peut posséder un axe sensible au champ magnétique et le capteur est configuré pour que l'axe sensible du composant soit perpendiculaire avec l'axe de déplacement des deux éléments.

Pour les deux paires d'aimants, les aimants d'une même paire peuvent être au contact l'un de l'autre ou sont distants l'un de l'autre.

Afin de concentrer le flux magnétique à l'intérieur de l'entrefer, le capteur peut comprendre des aimants complémentaires disposés en extrémité polaire de chacun des aimants des deux paires selon une configuration de Halbach.

Le composant peut être un interrupteur sensible au champ magnétique ou peut mettre en œuvre l'effet Hall pour détecter une variation de champ magnétique.

L'invention sera mieux comprise et d'autres avantages apparaîtront à la lecture de la description détaillée d'un mode de réalisation donné à titre d'exemple, description illustrée par le dessin joint dans lequel :
la figure 1a représente schématiquement le principe de mesure d'un composant sensible à un champ magnétique par rapport à un aimant permanent unique ;
la figure 1b représente, pour une mesure réalisée dans le cadre de la figure 1a, l'information issue du composant en fonction du déplacement de l'aimant ;
la figure 2a représente schématiquement une autre configuration à plusieurs aimants accolés ;
la figure 2b représente, pour une mesure réalisée dans le cadre de la figure 2a, l'information issue du composant en fonction du déplacement des aimants ;
la figure 3 représente schématiquement une configuration préférée d'un capteur selon l'invention ;
la figure 4 représente une variante de la configuration de la figure 3.

Par souci de clarté, les mêmes éléments porteront les mêmes repères dans les différentes figures.

L'invention est relative à un capteur destiné à déterminer la position relative de deux objets physiques d'un système, les deux objets se déplaçant l'un par rapport à l'autre selon une trajectoire prédéfinie pouvant varier dans une plage de tolérance. La variation de la trajectoire peut être due à différentes causes, comme notamment les tolérances de fabrication de différentes pièces mécaniques formant les deux objets physiques et de la liaison reliant les deux objets physiques. De plus, lors du fonctionnement du système, la trajectoire peut évoluer en fonction des conditions d'environnement, et notamment de la température à laquelle est soumise chaque pièce mécanique du système. La distance peut notamment varier en fonction de la température ambiante et aussi en fonction d'échauffements dus au fonctionnement du système. Dans un système électrique, il peut s'agir par exemple de pertes par effet Joule d'un moteur situé à proximité qui peuvent échauffer certaines pièces mécaniques.

Le capteur selon l'invention est formé de deux éléments destinés à être fixés chacun sur l'un des deux objets physiques dont on souhaite déterminer la position relative. Par la suite, on pourra définir un objet fixe et un objet mobile ou encore un élément fixe et un élément mobile du capteur. La notion de fixe et de mobile doit simplement être comprise de façon relative en fonction d'un repère attaché à l'un des deux objets.

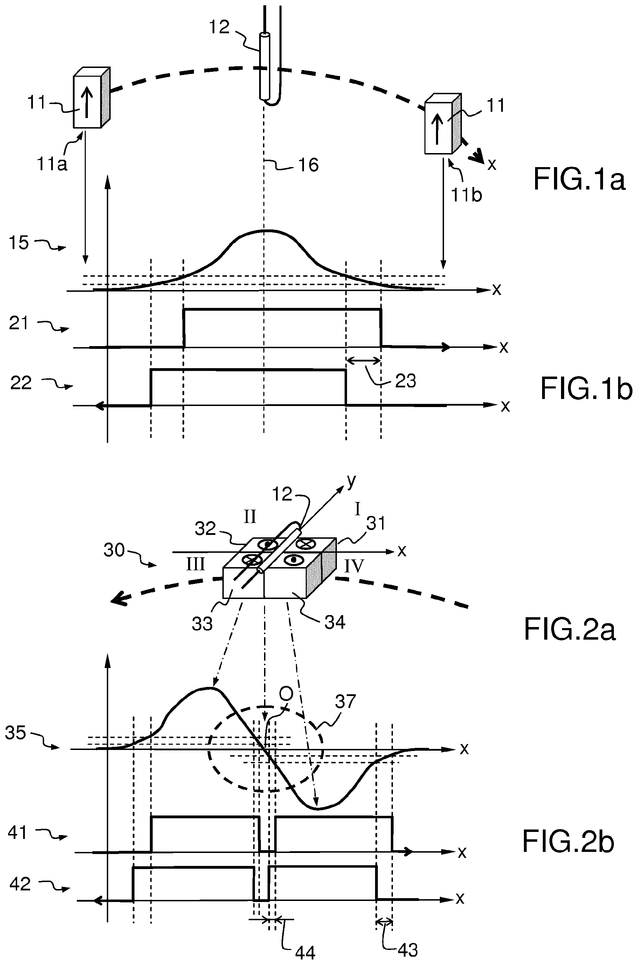

La figure 1a représente schématiquement un aimant permanent 11 se déplaçant par rapport à un composant 12 sensible à un champ magnétique. L'aimant permanent 11 suit une trajectoire évoluant entre deux positions extrêmes 11a et 11b. Une flèche est représentée sur l'aimant permanent 11. Cette flèche représente l'orientation des pôles de l'aimant 11. Conventionnellement, l'origine de la flèche représente le pôle Sud et l'extrémité de la flèche, le pôle Nord. Le composant 12 est par exemple un interrupteur sensible au champ magnétique connu dans la littérature anglo-saxonne sous le nom de relais Reed. Plus précisément, l'interrupteur du relais est ouvert si le champ magnétique est nul. Au-delà d'un seuil de champ magnétique, l'interrupteur est fermé. Il est bien entendu possible de choisir un composant possédant un fonctionnement inverse : interrupteur fermé lorsque le composant 12 est soumis à un champ magnétique nul et ouvert au-delà du seuil. Ce type de composant présente l'avantage d'un coût de reviens faible. Alternativement, il est bien entendu possible de mettre en œuvre d'autres types de composants sensibles à un champ magnétique, tel que par exemple un capteur à effet hall.

La figure 1b représente trois courbes fonctions de la trajectoire de l'aimant 11, trajectoire représentée en abscisse. Une première courbe 15 représente l'intensité du champ magnétique reçu par le composant 12 le long de la trajectoire de l'aimant 11. Dans les positions 11a et 11b de l'aimant, le champ magnétique reçu par la composant 12 est sensiblement nul. La courbe 15 a sensiblement la forme d'une courbe en cloche dont le maximum est obtenu lorsque l'aimant 11 est au plus près du composant 12. La courbe 15 est symétrique par rapport à un axe vertical 16 passant par le maximum de la courbe 15.

Le composant 12, sous forme d'interrupteur, peut délivrer un signal binaire représentatif de son état ouvert ou fermé. Deux courbes 21 et 22 représentent sous forme binaire l'état du composant 12. Un niveau haut du signal représente conventionnellement un état fermé et un niveau bas un état ouvert. Le composant 12 est par exemple fermé lorsqu'il est soumis à un champ magnétique d'intensité supérieure à un seuil. Il est également possible de mettre en œuvre un composant 12 dont le fonctionnement est inverse, c'est-à-dire un composant formé d'un interrupteur s'ouvrant lorsqu'il est soumis à un champ magnétique d'intensité supérieure à un seuil.

La courbe 21 représente l'état binaire du composant 12 lorsque l'aimant 11 se déplace de la position 11a vers la position 11b et le courbe 22 représente l'état binaire du composant 12 lorsque l'aimant 11 se déplace de la position 11b vers la position 11a. On a constaté que pour ce type de composant 12, le seuil d'ouverture et le seuil de fermeture ne sont pas strictement identiques, d'où le décalage, noté 23, des deux courbes qui ne se superposent pas parfaitement, d'où la difficulté à déterminer une position de référence précise du composant 12 par rapport à l'aimant 11. Ajouté à ce décalage d'éventuelles fluctuations de la courbe 15 dues notamment aux variations de température du système qui sont susceptibles de modifier la relation entre un changement d'état du composant 12 et la position de l'aimant 11 par rapport au composant 12.

La figure 2a représente une autre configuration dans laquelle un ensemble 30 de quatre aimants 31, 32, 33 et 34 solidaires les uns des autres se déplace par rapport au composant 12. Les axes passant par les pôles des quatre aimants sont tous parallèles. Dans un plan perpendiculaire aux axes passant par les pôles, on peut tracer un repère orthogonal O,x,y. Les quatre aimants 31, 32, 33 et 34 sont tous situés d'un coté du plan et affleurent le plan du repère. Le composant 12 se déplace à proximité de l'ensemble 30 de l'autre coté du plan, en suivant une trajectoire suivant l'un des axes du repère, l'axe O,x dans l'exemple représenté. De façon classique, on définit quatre quadrants I, II, III et IV dans le repère O,x,y en les ordonnant dans le sens trigonométrique autour de l'origine O du repère. Les quatre aimants 31, 32, 33 et 34 sont disposés chacun dans un quadrant du repère. Dans deux quadrants consécutifs, les pôles des aimants sont alternés. Plus précisément dans le quadrant I, l'aimant 31 présente son pôle Sud dans le plan du repère, dans le quadrant II, l'aimant 32 présente son pôle Nord dans le plan, dans le quadrant III, l'aimant 33 présente son pôle Sud dans le plan et dans le quadrant IV, l'aimant 34 présente son pôle Nord dans le plan.

La figure 2b représente, pour la configuration de la figure 2a et de façon semblable à la figure 1b, trois courbes fonctions de la trajectoire de l'ensemble 30, trajectoire représentée en abscisse. Une première courbe 35 représente l'intensité du champ magnétique reçu par le composant 12 le long de la trajectoire de l'ensemble 30. Lorsque le composant 12 est au dessus des quadrants II et III, l'intensité du champ magnétique reçu par le composant 12 est positive et lorsque le composant 12 est au dessus des quadrants I et IV, l'intensité du champ magnétique reçu par le composant 12 est négative. La courbe 35 est symétrique par rapport au point O où le composant 12 passe des quadrants II et III vers les quadrants I et IV. On s'intéresse principalement à la portion de la courbe 35 située au voisinage du centre de symétrie O, portion entourée d'un pointillé 37 sur la figure 2b. Dans cette portion, la courbe 35 forme sensiblement une droite dont la pente est fonction de la géométrie des aimants 31 à 34 et de leurs propriétés magnétiques. Pour mieux comprendre l'interaction entre l'ensemble d'aimants 30 et le composant 12, la pente de la courbe 35 au voisinage du point O a été réduite.

Comme précédemment, le seuil d'ouverture et le seuil de fermeture du composant 12 ne sont pas identiques dans les deux sens de déplacement du composant 12 par rapport à l'ensemble 30 selon l'axe O,x. Deux courbes 41 et 42 représentent sous forme binaire l'état du composant 12 en fonction du sens de déplacement du composant 12 le long de l'axe O,x. La courbe 41 représente l'état du composant 12 lorsqu'il se déplace dans le sens des x positifs et la courbe 42 lorsqu'il se déplace dans le sens inverse. A l'extérieur de la portion entourée du pointillé 37, on retrouve un décalage 43 semblable au décalage 23 précédemment décrit. A l'intérieur de la portion entourée du pointillé 37 on retrouve un décalage 44 plus faible que le décalage 43, ce qui permet de localiser plus précisément le composant 12 par rapport à l'ensemble 30 que dans la configuration décrite à l'aide des figures 1a et 1b.

Les courbes 35, 41 et 42 présentent l'intensité du champ magnétique reçu par le composant 12 ainsi que son état binaire pour une température donnée des aimants 31 à 34 et pour une trajectoire du composant 12 suivant précisément l'axe O,x. Or, dans la pratique, la température des aimants 31 à 34 et les variations de la trajectoire influent de façon importante sur la forme de la courbe 35 et notamment sur la pente de cette courbe dans la portion entourée du pointillé 37. Une modification de la pente entraine une variation du décalage 44 et donc une variation de la précision de la mesure de position issue du capteur. Des essais faits en interne ont montré que si la trajectoire du composant 12 atteignant la moitié de la largeur d'un des aimants 31 à 34, le capteur devenait inopérant.

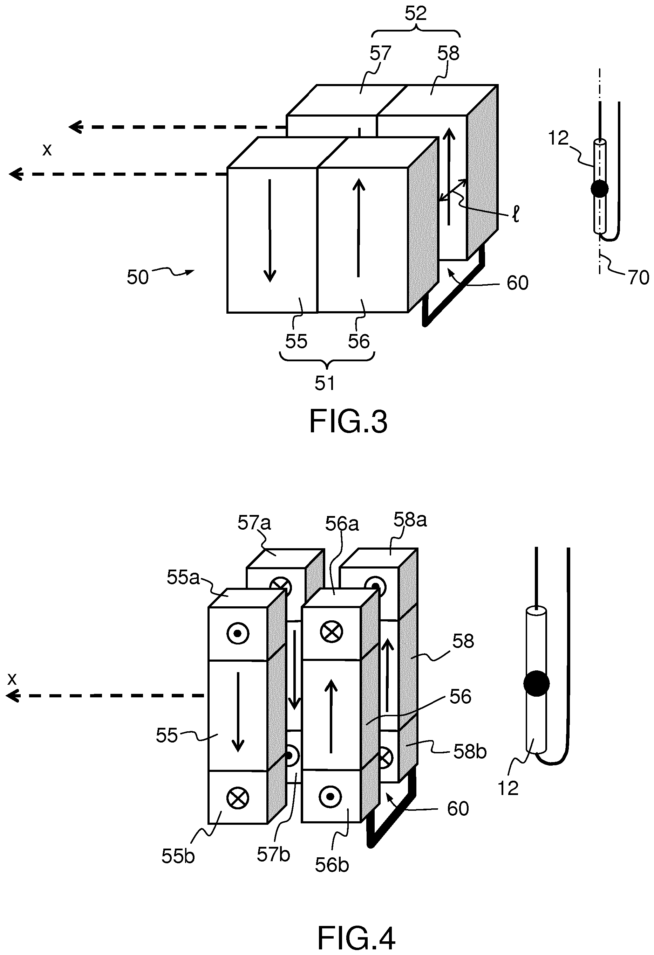

La figure 3 représente schématiquement le capteur selon l'invention. Le capteur comprend le composant 12 sensible à une variation de champ magnétique et un ensemble 50 comprenant deux paires d'aimants 51 et 52 immobiles les uns par rapport aux autres. Le composant 12 peut se déplacer par rapport à l'ensemble 50. Le composant 12 et l'ensemble 50 forment un capteur destiné à déterminer la position relative de deux objets physiques l'un par rapport à l'autre. Le composant est fixé à l'un des objets et l'ensemble 50 est fixé à l'autre des objets. Le composant 12 délivre une information relative à sa position par rapport à l'ensemble 50.

La paire 51 comprend deux aimants 55 et 56 dont les axes polaires passant par leurs pôles respectifs sont parallèles. De même, la paire 52 comprend deux aimants 57 et 58 dont les axes passant par leurs pôles respectifs sont parallèles. Dans chacune des paires 51 et 52, l'orientation de chacun des aimants est alternée. Pour chaque aimant, l'axe passant les pôles est représenté par une flèche verticale conventionnellement orientée du pôle Sud vers le pôle Nord de l'aimant. Pour l'aimant 55, le pôle Nord est représenté vers le bas et pour l'aimant 56, le pôle Nord est représenté vers le haut. Il est bien entendu possible d'inverser l'orientation des deux aimants 55 et 56. Il en est de même pour la paire 52 où l'orientation des deux aimants est également alternée.

De plus, un entrefer 60 est formé entre les deux paires 51 et 52. L'entrefer 60 est configuré pour y permettre le passage du composant 12. On définie une largeur l de l'entrefer comme la distance séparant les deux paires et une hauteur h de l'entrefer définie parallèlement aux axes des aimants. La trajectoire du composant 12 dans l'entrefer 60 se fait perpendiculairement à la hauteur et à la largeur de l'entrefer 60. La largeur l et la hauteur h sont configurées pour permettre le passage du composant avec une tolérance suffisante pour accepter toute tolérance mécanique et toute dilatation thermique du système dans lequel est disposé le capteur.

De part et d'autre de l'entrefer, chaque aimant d'une paire fait face à un aimant de l'autre paire et les aimants se faisant face possèdent la même orientation. Dans l'exemple représenté, les aimants 55 et 57 ont la même orientation, c'est-à-dire leur pôle Sud en haut et les aimants 56 et 58 ont la même orientation, c'est-à-dire leur pôle Nord en haut.

Avec cette disposition, l'intensité du champ magnétique dans l'entrefer est constante sur toute la largeur l de l'entrefer 60 et sur une grande partie de sa hauteur h. En conséquence, le capteur admet des écarts de positionnement du composant 12 selon la hauteur et la largeur de l'entrefer sans modification de l'intensité magnétique reçu par le composant 12.

L'intensité du champ magnétique dans l'entrefer 60 est principalement fonction de la largeur de l'entrefer et des caractéristiques magnétiques des aimants. Plus l'entrefer est large, plus l'intensité diminue. Il est donc avantageux de réduire au maximum la largeur de l'entrefer 60. Par ailleurs, les relais « Reed » sont sensibles au champ magnétique selon un seul axe repéré 70 sur la figure 3. Pour assurer un fonctionnement optimal, le capteur est configuré pour que l'axe 70 du composant 12 soit parallèle aux axes passant par les pôles des différents aimants. Il est également possible de mettre en œuvre un composant 12 possédant plusieurs axes sensibles. Au moins l'un de ses axes sensibles est parallèle avec les axes passant par les pôles des différents aimants, souvent appelés axes d'aimantation.

Sur la figure 3, les aimants 55 et 56 de la paire 51 sont au contact l'un de l'autre et les aimants 57 et 58 de la paire 52 sont également au contact l'un de l'autre. Cela permet une inversion rapide du champ magnétique dans l'entrefer 60 au niveau de la jonction des deux aimants d'une même paire. Alternativement, il est possible d'écarter les deux aimants d'une même paire. Cet écartement permet de maitriser la variation du champ magnétique en fonction de l'axe x.

La figure 4 représente une variante de la configuration de la figure 3 dans laquelle des aimants complémentaires sont ajoutés en extrémité polaire des aimants de l'ensemble 50. Pour un aimant donné, il est possible de l'assembler dans une structure de Halbach qui présente l'avantage de concentrer le flux magnétique selon une des faces de l'aimant. Appliqué à l'invention l'orientation des aimants complémentaires est choisie pour concentrer le flux dans l'entrefer 60. Cette configuration tend à concentrer le flux magnétique dans l'entrefer 60.

Pour un aimant donné, les deux aimants complémentaires sont repérés avec la référence de l'aimant principal suivi de la lettre a et b. par exemple, pour l'aimant 55, un aimant complémentaire 55a est disposé sur sa face polaire Sud. L'axe polaire de l'aimant complémentaire 55a est orienté selon la largeur de l'entrefer 60 avec son pôle Sud bordant l'entrefer 60. L'aimant complémentaire 55b est disposé sur la face polaire Nord de l'aimant 55. L'axe polaire de l'aimant complémentaire 55b est également orienté selon la largeur de l'entrefer 60 mais avec son pôle Nord bordant l'entrefer 60. L'orientation des aimants complémentaires des aimants principaux 56, 57 et 58 est représentée sur la figure 4 et se déduit par permutation pour obtenir pour chacun une structure de Halbach concentrant le flux magnétique dans l'entrefer 60.

## Revendications

1. Capteur de position comprenant deux éléments (12, 50) destinés à se déplacer l'un par rapport à l'autre, un premier des deux éléments comprenant un composant (12) sensible à un champ magnétique, **caractérisé en ce qu'**un second des deux éléments (50) comprend deux paires d'aimants (51, 52), **en ce que** dans chacune des paires, l'orientation de chacun des aimants (55, 56, 57, 58) est alternée et les axes polaires passant par leurs pôles respectifs sont parallèles, **en ce qu'**un entrefer (60) de largeur (l) est formé entre les deux paires d'aimants (51, 52), la largeur (l) définissant une distance séparant les deux paires d'aimants (51, 52) et étant configurée pour y permettre le passage du composant (12) selon un axe (x) perpendiculaire aux axes des pôles des aimants et **en ce que** chaque aimant d'une paire fait face à un aimant de l'autre paire et les aimants se faisant face possédant la même orientation.

2. Capteur de position selon la revendication 1, **caractérisé en ce que** le composant (12) possède un axe (70) sensible au champ magnétique et **en ce que** le capteur est configuré pour que l'axe sensible (70) du composant (12) soit perpendiculaire à l'axe (x) de déplacement des deux éléments (12, 50).

3. Capteur de position selon l'une des revendications précédentes **caractérisé en ce que** pour les deux paires d'aimants (51, 52), les aimants (55, 56 ; 57, 58) d'une même paire sont au contact l'un de l'autre.

4. Capteur de position selon l'une des revendications 1 à 2, **caractérisé en ce que** pour les deux paires d'aimants (51, 52), les aimants (55, 56 ; 57, 58) d'une même paire sont distants l'un de l'autre.

5. Capteur de position selon l'une des revendications précédentes, **caractérisé en ce qu'**il comprend des aimants complémentaires (55a, 55, 56a, 56b, 57a, 57b, 58a, 58b) disposés en extrémité polaire de chacun des aimants (55, 56 ; 57, 58) des deux paires (51, 52) selon une configuration de Halbach afin de concentrer le flux magnétique à l'intérieur de l'entrefer (60).

6. Capteur de position selon l'une des revendications précédentes, **caractérisé en ce que** le composant (12) est un interrupteur sensible au champ magnétique.

7. Capteur de position selon l'une des revendications 1 à 5, **caractérisé en ce que** le composant (12) met en œuvre l'effet Hall pour détecter une variation de champ magnétique.

## Patentansprüche

1. Positionssensor, umfassend zwei Elemente (12, 50), welche dazu bestimmt sind, sich in Bezug aufeinander zu bewegen, wobei ein erstes der beiden Elemente eine Komponente (12) umfasst, welche magnetfeldempfindlich ist, **dadurch gekennzeichnet, dass** ein zweites der beiden Elemente (50) zwei Magnetpaare (51, 52) umfasst, dadurch, dass in jedem der Paare die Ausrichtung eines jeden der Magnete (55, 56, 57, 58) abwechselt und die Polachsen, welche ihre jeweiligen Pole passieren, parallel sind, dadurch, dass ein Spalt (60) mit einer Breite (l) zwischen den beiden Magnetpaaren (51, 52) gebildet ist, wobei die Breite (l), welche einen Abstand definiert, welcher die beiden Magnetpaare (51, 52) trennt, konfiguriert ist, um dort das Passieren der Komponente (12) entlang einer Achse (x) zu ermöglichen, welche rechtwinklig zu den Achsen der Pole der Magnete ist, und dadurch, dass jeder Magnet eines Paares einem Magneten des anderen Paares gegenüber liegt und die Magnete, welche einander gegenüberliegen, dieselbe Ausrichtung aufweisen.

2. Positionssensor nach Anspruch 1, **dadurch gekennzeichnet, dass** die Komponente (12) eine magnetfeldempfindliche Achse (70) aufweist und dadurch, dass der Sensor konfiguriert ist, damit die empfindliche Achse (70) der Komponente (12) rechtwinklig zu der Bewegungsachse (x) der beiden Elemente (12, 50) ist.

3. Positionssensor nach einem der vorhergehenden Ansprüche, **dadurch gekennzeichnet, dass** bei den beiden Magnetpaaren (51, 52) die Magnete (55, 56; 57, 58) eines selben Paares miteinander in Kontakt stehen.

4. Positionssensor nach einem der Ansprüche 1 bis 2, **dadurch gekennzeichnet, dass** bei den beiden Magnetpaaren (51, 52) die Magnete (55, 56; 57, 58) eines selben Paares voneinander beabstandet sind.

5. Positionssensor nach einem der vorhergehenden Ansprüche, **dadurch gekennzeichnet, dass** er zusätzliche Magnete (55a, 55, 56a, 56b, 57a, 57b, 58a, 58b) umfasst, welche am Polende eines jeden der Magnete (55, 56; 57, 58) der beiden Paare (51, 52) entsprechend einer Halbach-Konfiguration angeordnet sind, um den Magnetfluss im Innern des Spaltes (60) zu konzentrieren.

6. Positionssensor nach einem der vorhergehenden Ansprüche, **dadurch gekennzeichnet, dass** die Komponente (12) ein magnetfeldempfindlicher Schalter ist.

7. Positionssensor nach einem der Ansprüche 1 bis 5, **dadurch gekennzeichnet, dass** die Komponente (12) den Hall-Effekt verwendet, um eine Magnetfeldvariation zu erkennen.

## Claims

1. A position sensor comprising two elements (12, 50) that are intended to move with respect to one another, a first of the two elements comprising a component (12) that is sensitive to a magnetic field, **characterized in that** a second of the two elements (50) comprises two pairs of magnets (51, 52), **in that** in each of the pairs, the orientation of each of the magnets (55, 56, 57, 58) is alternated, and the polar axes passing through their respective poles are parallel, **in that** an air gap (60) of a width (1) is formed between the two pairs of magnets (51, 52), the width (1) defining a distance separating the two pairs of magnets (51, 52) and being configured to allow the component (12) to pass there through along an axis (x) that is perpendicular to the axes of the poles of the magnets and **in that** each magnet of one pair facing a magnet of the other pair and the magnets facing one another having the same orientation.

2. The position sensor according to claim 1, **characterized in that** the component (12) has an axis (70) that is sensitive to the magnetic field and **in that**, the sensor is configured so that the sensitive axis (70) of the component (12) is perpendicular to the axis (x) of movement of the two elements (12, 50).

3. The position sensor according to one of the preceding claims, **characterized in that** for the two pairs of magnets (51, 52), the magnets (55, 56, 57, 58) of one and the same pair make contact with one another.

4. The position sensor according to one of claims 1 to 2, **characterized in that** for the two pairs (51, 52) of magnets (55, 56, 57, 58) the magnets of one and the same pair are at a distance from one another.

5. The position sensor according to one of the preceding claims, **characterized in that** it comprises additional magnets (55a, 55, 56a, 56b, 57a, 57b, 58a, 58b) that are positioned at the pole end of each of the magnets (55, 56; 57, 58) of the two pairs (51, 52) in a Halbach configuration in order to concentrate the magnetic flux inside the air gap (60).

6. The position sensor according to one of the preceding claims, **characterized in that** the component (12) is a switch that is sensitive to the magnetic field.

7. The position sensor according to one of claims 1 to 5, **characterized in that** the component (12) makes use of the Hall effect in order to detect a variation in magnetic field.
